(19) Europäisches Patentamt
European Patent Office
Office européen des brevets

(11)  **EP 4 070 384 B1**

(12)  **EUROPEAN PATENT SPECIFICATION**

(45) Date of publication and mention
of the grant of the patent:
**17.04.2024  Bulletin 2024/16**

(21) Application number: **21830472.3**

(22) Date of filing: **09.12.2021**

(51) International Patent Classification (IPC):
$H01L\ 27/06^{(2006.01)}$    $H01L\ 27/082^{(2006.01)}$
$H01L\ 29/06^{(2006.01)}$    $H01L\ 29/10^{(2006.01)}$
$H01L\ 29/735^{(2006.01)}$   $H01L\ 27/098^{(2006.01)}$
$H01L\ 29/66^{(2006.01)}$    $H01L\ 29/808^{(2006.01)}$

(52) Cooperative Patent Classification (CPC):
**H01L 27/0623; H01L 29/0692; H01L 29/1008;
H01L 29/6625; H01L 29/735;** H01L 27/082;
H01L 27/098; H01L 29/808

(86) International application number:
**PCT/GB2021/053234**

(87) International publication number:
**WO 2022/123261 (16.06.2022 Gazette 2022/24)**

(54) **A TRANSISTOR DEVICE**

TRANSISTORVORRICHTUNG

DISPOSITIF DE TRANSISTOR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **09.12.2020  GB 202019401
08.11.2021  GB 202116047**

(43) Date of publication of application:
**12.10.2022  Bulletin 2022/41**

(73) Proprietor: **Search for the Next Ltd
Nottingham NG7 2TU (GB)**

(72) Inventors:
• **SUMMERLAND, David
Nottingham NG7 2TU (GB)**

• **LIGHT, Roger
Nottingham NG7 2TU (GB)**
• **KNIGHT, Luke
Nottingham NG7 2TU (GB)**

(74) Representative: **Tolfree, Adam Joseph Benjamin
et al
Tolfree Patents & Trademarks
Toll Drove
Manea, Cambridgeshire PE15 0JX (GB)**

(56) References cited:
**EP-A2- 0 268 426    WO-A1-2011/053932
US-A- 4 496 963    US-B1- 6 251 716**

## Description

The present invention relates to a novel transistor having, among other advantages, improved current gain characteristics over conventional lateral bipolar junction transistors (BJTs).

The semiconductor structure and doping configuration of a BJT is such that current between the emitter and collector (the controlled current) is a consequence of movement of both electron and electron hole charge carriers, referred to as bipolar conduction.

In contrast in a field effect transistor (FET) or Junction Field Effect transistor (JFET) current between the source and drain terminals (the controlled current) is primarily, if not solely, attributable to movement of either electrons or electron holes but not both, referred to as unipolar conduction or single-carrier-type operation.

US6251716B1, US200316704A1, US2009206375, US4496963, EP0268426, WO2011/053932 and US6251716 are directed to JFET where current between the source and drain is primarily attributable to unipolar conduction.

According to a first aspect of the invention there is provided a transistor device according to claim 1.

By virtue of the presence of the channel, in what is otherwise a substantially conventional BJT semiconductor structure, the device can be operated either as a normally ON device or a normally OFF device depending on the voltage applied across the emitter and collector terminals.

The value of the threshold voltage is tied with the length of the channel that extends between the emitter and collector regions and typically thus also the separational distance between the emitter region and collector region. Consequently, for an anticipated emitter-collector voltage range, it is possible to fabricate the transistor device to operate either as normally ON or normally OFF by selecting the length of the channel.

The same mask process can be used to define the spacing for all transistor devices in the circuit. Advantageously, this makes it possible to fabricate an integrated circuit comprising both normally ON and normally OFF transistors without additional processing steps. Such circuits can be used to perform functions that would usually require use of complementary transistors, e.g. NMOS & PMOS, that require more semiconductor layers and/or production steps to implement. Applications that may benefit from this advance include logic gate circuits, analogue comparators and op-amp circuits.

When operating in the first condition, where the voltage placed across emitter and collector terminals (Vce) is greater than the first threshold, the transistor device functions as a normally ON device; the channel allows for unipolar conduction between the collector and emitter terminals, notwithstanding that there is no current through the base terminal.

When operating in the second condition, where the voltage across the emitter and collector terminals is below the first threshold value, the very small depth of the channel (a function of the small depth of the semiconductor layer that provides the channel) means that a depletion region, which exists about the first diode junction, is sufficient that the channel has a high enough resistance to prevent current through the channel.

It can be thought that where Vce is greater than the threshold, it is large enough to overcome the depletion region allowing for a current between the emitter and collector. As the length of the channel increases, the value of Vce needed to overcome the depletion region also increases.

The very small absolute depth of the channel, as well as its relatively small depth compared with that of the sub-region of the base, means that where operated in the third condition, i.e. where the voltage across the emitter and base terminals (Vbe) is greater than the forward bias voltage of the base-emitter diode junction Vft, a majority of the current through the base terminal will be attributed to bipolar conduction through the emitter and sub-base regions rather than through the channel.

Notwithstanding, when operating in the third condition the presence of the channel provides the transistor with improved gain characteristics compared with BJT transistors with conventional structures. This is thought to be because the channel provides a conduction path between the emitter and collector regions without crossing a diode junction and which thus provides relatively low resistance.

A consequence of the manner in which the transistor device functions is that as the value of Vbe changes above Vft, the proportion of Ice attributable to bipolar conduction and unipolar conduction changes and thus the current gain of the transistor changes; as the proportion of bipolar conduction increases the current gain drops.

A further unexpected but advantageous feature of the novel transistor design is that it allows, through selection of the channel length for a known operating range for Vce, a normally OFF transistor that switches ON at values of Vbe below the forward bias voltage of the base emitter diode junction.

Expressed another way, when operated in a fourth condition in which the voltage across the emitter and collector terminals is between the first threshold (Vt) and a second threshold (Vt'), where |Vt'| < |Vt|, the transistor device, which operates as a normally OFF transistor, switches ON when Vbe is less that the forward bias voltage (Vft) of the base emitter diode junction.

When operating in the fourth condition, current between the emitter and collector is a result of unipolar conduction through the channel and consequently the device has a higher gain compared with when operating in the fourth condition albeit with a smaller maximum current between the emitter and collector.

The transistor device, where adapted to switch between OFF and the fourth condition, has a channel which is too long, when Vbe =0, for a Vce of a value less than Vt to overcome the depletion region about the first diode junction. Nevertheless, the channel is short enough that application of a small forward voltage across the base and emitter terminals (Vbe greater than 0), whilst not being enough to overcome a depletion region about the base emitter diode junction (Vbe < Vft), and thus Ibe=0, is enough to weaken the intrinsic depletion region about the first diode junction to an extent to allow current between the emitter and collector via the channel. The minimum value of Vbe required to operate the transistor device in the fourth condition will depend on the value of Vce and Vt for that transistor device.

An application where this has utility includes a driver circuit where it is advantageous for first stage transistors to have reduced bipolar conduction (i.e. greater unipolar conduction - possibly solely unipolar conduction) to provide higher gain, whereas second stage transistors have increased bipolar conduction to allow for higher current rating whilst minimising the surface (plane) area of the device.

Advantageously, the presence of the channel allows for the transistor device to switch between ON (operating in first or fourth conditions) and OFF in response to a change in Vbe that is less than the absolute value of the forward voltage of the base-emitter diode (Vft). This allows, for example, two transistor devices of the same configuration, e.g. both NPN or both PNP, to be used to switch both sides (high and low) of a driver circuit, rather than the conventional requirement for a complementary pair.

A suitable depth for the channel will depend on the values of Vce at which the transistor is designed to operate and/or the doping concentration of the channel.

For example, for a transistor adapted to operate at voltages between 0V and |5V|, a channel depth below 0.25 $\mu$m and favourably 0.1 $\mu$m or less may be suitable.

Nevertheless, for a given operating voltage, the maximum depth of the channel permitted will be notably smaller than would exist for a JFET designed to operate at a comparable operating voltage.

In contrast, the depth of the sub-region extending in the opposite direction from the first diode junction may be equal or greater than five times that of the channel. In some embodiments the depth of the sub-region may be at least twenty time that of the channel.

The sub-region may comprise a first portion and a second portion, and wherein: the first portion has a higher net doping concentration than the second portion; the base terminal electrically connects to the second portion through the first portion; and in which the second portion interfaces with the channel to provide the first diode junction, and interfaces with both the emitter region and the collector region to form the further diode junctions. This ensures that a relatively high doped region can be used at the base contact to provide an ohmic contact, whilst a lower doped region interfaces with the channel, emitter and collector regions.

Ensuring predominately bipolar conduction when operating within the third condition requires careful selection of the net doping concentrations of the emitter region, collector region and sub-region of the base, as well as the spacing between the emitter and collector regions, also known as the base width. The exact values will depend on variables such as the expected operating voltage ranges of Vce and Vbe and the semiconductor fabrication process size and material used. The approach used to select values for these variables is the same and common practice for designing a conventional BJT structure and so will be readily understood by the person skilled in the art.

The net doping concentration of the channel may be equal to or less than (e.g. between 0.1 and 1 times) the net doping concentration of sub-region. This ensures the depletion region at the first diode junction preferentially exists within the channel compared within the sub-region. For example, where the channel is comprised from P type semiconductor material and the sub region is comprised from an N type semiconductor material, the net doping concentration of P type dopant in the channel may be between 0.1 and 1 times the net concentration of N type dopant within the sub region.

To provide good conduction characteristics within the first part of the sub region, the first part of the sub-region may have a net doping concentration between 1e16 per cm3 and 5e17 per cm3 inclusive.

Good bipolar conduction characteristics also depend on a relatively small lateral separation between the collector and emitter regions, therefore the lateral separation between the collector and emitter regions is less or equal to 1.5 microns.

The emitter and/or collector regions may lie at least partly within the sub-region of the base.

The invention will now be described by way of example with reference to the following figures:

Figure 1 is a schematic cross-section of a semiconductor structure implementing a transistor;

Figure 2 is a chart illustrating how the operating characteristics of the transistor device of Fig 1 varies with changes in Vbe and Vce.

Figure 3A is a schematic cross-section of the device of Fig 1 showing the transistor configured in an ON condition and in which conduction between the emitter and collector is primarily attributable to bipolar conduction;

Figure 3B is a schematic cross-section of the device of Fig 1 showing the transistor configured in an OFF condition;

Figure 3C is a schematic cross-section of the device of Fig 1 showing the transistor configured in an ON condition and in which conduction between the emitter and collector is primarily attributable to unipolar conduction;

**Figure 4A** is a schematic cross-section of a transistor device similar to Fig 1 but with a shorter spacing X, configured in an ON condition in which current between the emitter and collector is primarily attributable to unipolar conduction;

**Figure 4B** is a schematic cross-section of the transistor device of Fig 4A showing the transistor configured in an OFF condition;

**Figure 5A** is a schematic cross-section of a variant semiconductor structure to implement a transistor device;

**Figure 5B** is a plan view of the transistor implemented by the semiconductor structure illustrated in Fig 5A; and

**Figures 6A-6I** are schematic representations illustrating process stages for the manufacture of the transistor device of Figures 5.

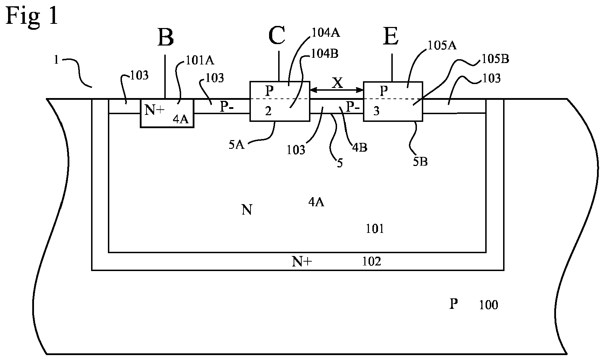

With reference to Fig 1 there is shown a novel transistor device 1. The transistor device 1 was conceived as an improvement to bipolar junction transistor (BJT) devices and in certain aspects operates in a similar fashion. For this reason, the terminals of the device 1 are referred to using BJT nomenclature.

The device 1, which in this example is of a PNP type and is not shown to scale, is comprised from semiconductor material doped to provide a collector region 2, an emitter region 3 and a base region 4. The base region 4 lies between the collector region 2 and emitter region 3.

The collector region 2 and emitter region 3 are both of P type semiconductor, and as is conventional, the emitter region 3 may be more heavily doped than the collector region 2. For example, the net doping concentration of the collector region 2 may be greater or equal to $1 \times 10^{18}$ cm$^{-3}$, and the net doping concentration at the emitter region 3 may be greater or equal to $2 \times 10^{18}$ cm$^{-3}$. Alternatively, for ease of manufacture, they may instead have substantially the same net doping concentration. A collector terminal C is connected to the collector region 2, an emitter terminal E to the emitter region 3, and a base terminal B to the base region 4.

In contrast with a conventional BJT the base region 4 of the transistor device 1 is comprised from two regions of different type semiconductor: a first region of N type material, herein after the N type base region 4A, and second region, hereafter referred to as the channel 4B, of P type material.

The base terminal B connects to the base region 4 through the N type region 4A. The N type base region 4A directly interfaces with the channel 4B to form a PN junction 5. The N type base region 4A directly interfaces with both the collector region 2 and emitter region 3.

The channel 4B extends between and directly interfaces with the collector region 2 and emitter region 3. The channel 4B has a very weak net doping concentration compared with that of the collector region 2 and emitter region 3. For example, the net doping concentration of the channel may be less or equal to $5 \times 10^{16}$ cm$^{-3}$.

Further, the channel 4B is formed to have a depth, i.e. dimension extending orthogonally from NP junction 5, which is significantly shallower than is conventional with junction field effect transistor (JFET).

The subregion is comprised from a first part and a second part. The net concentration of N dopant in the first part may be around 1e17/cm3. The net doping concentration in the second part may be, for example, about 1e18/cm3 or 1e19/cm3.

Below describes the semiconductor structure implementing the above mentioned features.

There is provided a P type substrate 100, which may be, for example, a silicon wafer or layer deposited by epitaxy on top of the wafer. Within the substrate 100 is provided an N type region 101. Separating the N type region 101 from the substrate 100 is an N+ region 102. Within the N type region 101 is provided a further N+ region 101A that extends to a surface of the substrate material. The N type region 101 and further N+ region 101A constitute the N type base region 4A of the transistor device 1, with the base contact B connected via the further N+ region 101A. The net concentration of N dopant in the N region 101 may be around 1e17/cm3. The net doping concentration of the N+ region 102 and further N+ region 101A may be, for example, about 1e18/cm3 or 1e19/cm3.

Extending across the top of the N region 101 is a lightly doped P- region 103 that provides channel 4B and interfaces with the N region 101 to provide the diode junction 5. The structure also includes two separated P regions 104, 105. A first part 104A, 105A of each P region 104, 105 is provided by respective separate portions of a P doped polysilicon layer. A second part 104B, 105B of each P region 104, 105 is formed in the silicon wafer and interfaces the N region 101 to provide respective diode junctions 5A 5B.

An example manufacturing process for the semiconductor structure is described. A first implant and diffusion process is used with a first mask to form the N+ region 102 in the P type substrate 100. Using a second mask the N region 101 is formed by counter doping the N+ region 101 with P dopant whereupon the N region 101 extends to the surface of the wafer.

Preferably without using a mask, the surface of the wafer is further doped with P dopant to form the P- layer 103 across the surface of the wafer. The net doping concentration of the P- region 103 may, for example, be 5e16/cm3 or less. The depth of the P- region 103 is kept very small by ensuring little or no diffusion takes place. The relative thickness of the P-layer 103 compared with the other layers is exaggerated in Fig 1 for intelligibility.

Using a third mask, N dopant is implanted through the wafer surface counter doping a portion of the P- region 103 to form the further N+ region 101A so that it is contiguous with the N region 101.

Using a forth mask, a layer of polysilicon material is deposited and etched to provide portions 104A 105A of the collector and emitter regions 2, 3. Using a fifth mask the polysilicon material is doped with P dopant and diffused downward to form second parts 104B 105B that interface with the N region 101.

Implantation of P dopant is followed by a short anneal, e.g. 10 seconds, to repair the crystal structure of the polysilicon and silicon wafer.

Modes of Operation

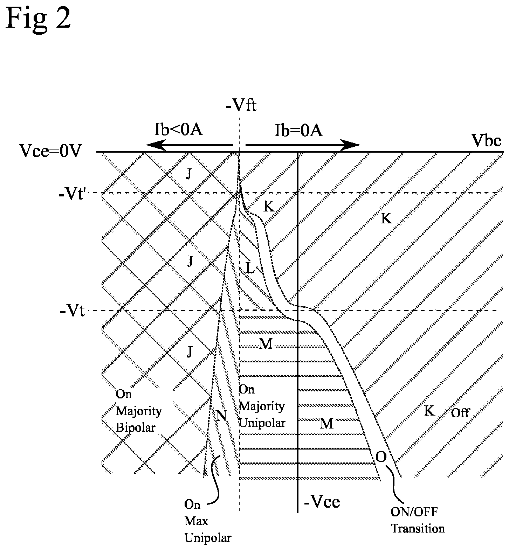

With reference to Figure 2, the operating characteristics or modes of the device of Fig 1 alter depending on the voltage across the collector terminal and emitter terminal (Vce) and the voltage across the base terminal and emitter terminal (Vbe).

With a PNP device, such as the one shown in Figure 1, irrespective of the mode of operation, it is normally operated with a negative Vce, i.e. the voltage applied to the collector is more negative than the voltage applied to the emitter, and Vbe may be either positive or negative with a negative base-emitter junction forward threshold voltage Vft. Any current through the base terminal will be negative (in other words current is drawn out through the base terminal). In contrast, a NPN device is normally operated with a positive Vce, has a positive Vft, and any current through the base will be positive (in other words current is pushed into the device through the base).

Five modes of operation are shown labelled K, J, L M & N. When the device is OFF and there is no current through any terminal, the device is operating in region K. When the device is ON it may operate in one of modes J, L, M and N.

When the device is ON (i.e. there a current between the collector and emitter) and there is no or *de minimus* current through the base terminal (i.e. Ib=0A), excluding any temporary switching current due to capacitance effects, the device is operating in regions L or M. When the device is ON (i.e. there is a non-zero current between the collector and emitter) and there is current through the base terminal (i.e. Ib<0A), the device is operating in regions J or N.

Operation with |Vce| < |Vt|

When the transistor device 1 operates with |Vce| smaller than |Vt|, the transistor device 1 functions as a normally OFF device. In other words, there is no current between the emitter 2 and collector 3 (the device is OFF (operating in (K) region)) when Vbe is zero.

If |Vbe| is increased such that the base-emitter diode junction 5B becomes forward biased (i.e. for a PNP transistor, Vbe becomes more negative than -Vft; for a NPN transistor, Vbe becomes more positive than Vft), then the device switches ON, operating in the ON Majority Bipolar region J, where current is drawn through the base terminal and the current between the collector and emitter is attributed in the majority to bipolar conduction.

Alternatively, if |Vbe| is increased in the opposite direction such that the base-emitter diode junction 5B becomes more reverse biased (i.e. for a PNP transistor, Vbe becomes more positive; for a NPN transistor, Vbe becomes more negative), then the device remains OFF (operating in region (K)).

Where |Vce| is greater than |Vt'| and less than |Vt|, the device operates in a similar manner as when |Vce| is less than |Vt'|, with the exception that as |Vbe| approaches but is less than |Vft|, the device enters the ON Majority Unipolar operating region L where the device is ON with zero current through the base terminal and the current between the collector and emitter is attributed in the majority to unipolar conduction.

As |Vbe| becomes greater than |Vft|, it enters a transition region N where the unipolar conduction current is at a maximum, and bipolar conduction current increases until bipolar conduction current is greater than unipolar conduction current whereupon the device operates in the ON majority bipolar conduction region J.

Advantageous a normally OFF device can be switched ON and operated in region L at a lower Vbe than existing BJTs, and, advantageously, lower than the base emitter diode junction forward voltage (Vft). When operating within L region the device has significantly higher current gain but lower magnitude of maximum collector current compared to operating within the region J for the same Vce. Because of the significantly lower Vbe the device when operating in the L region has a significantly higher current gain that existing BJTs - near infinite gain as there is substantially zero current through the base terminal.

Operation with |Vce| > |Vt|

When the transistor device 1 is operated with |Vce| greater than a threshold voltage |Vt|, the transistor device 1 functions as a normally ON device. In other words, there is more than a *de minimis* current between the emitter and collector when Vbe is zero, e.g. because the base terminal is floating or tied to the emitter.

When |Vce| is greater than |Vt| and Vbe is at or around zero, the transistor operates in the ON majority unipolar operating region M where there is zero current through the base terminal and the current between the collector and emitter is attributed in the majority to unipolar conduction.

As |Vbe| increases above Vft, such that the base-emitter diode junction 5B becomes forward biased (i.e. for a PNP transistor, Vbe becomes more negative than -Vft; for a NPN transistor, Vbe becomes more positive than Vft), then the device operates in the transition region N where unipolar conduction is at a maximum and the bipolar conduction increases. As |Vbe| increases further, the proportion of Ice that can be attributed to bipolar conduction becomes greater than that attributed to unipolar conduction current whereupon operation is ON Majority Bipolar (region J).

The magnitude of Vbe needed to operate in the J region increases with increasing magnitude of Vce.

Alternatively, if |Vbe| is increased in the opposite direction such that the base-emitter diode junction 5B becomes more reverse biased (i.e. for a PNP transistor, Vbe becomes more positive; for a NPN transistor, Vbe becomes more negative), then the device will switch OFF (operate region K).

Between the OFF region K and the ON Majority Unipolar regions L and M is a transition region O where the operation of the device is unpredictable or difficult to control. For example, if the collector current in the OFF region K is less than 1nA, and the collector current in the ON regions L and M is on the order of 1uA or greater, then the collector current within the transition region O will be of the order of 10nA to 100nA.

The device 1 has a lateral spacing between the collector region 2 and emitter region 3 of distance X which governs the length of the channel 4B. The values of Vt and Vt' are correlated to the spacing X between the emitter and collector regions. As the value of X increases, the magnitude of |Vt| and |Vt'| increase. To enable to device to have good bipolar conduction characteristics when operating in the J region the maximum value of X is typically 1.5 microns.

The nominal operating voltage range of a circuit governs the range of Vce values that will be applied to the transistors within it. With Vce known, the spacing X for each transistor device 1 within the circuit can be selected when designing the circuit to determine whether it operates as a normally ON or normally OFF device.

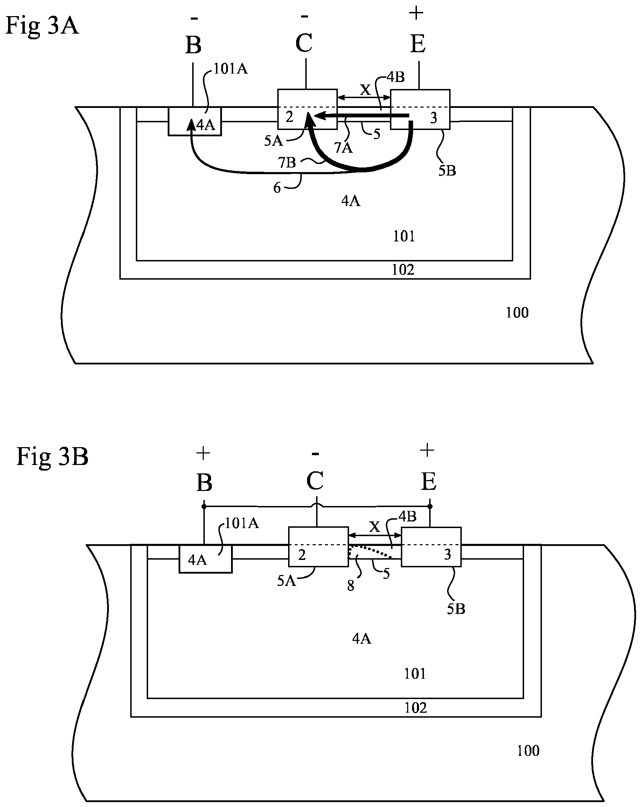

Figures 3A -3C illustrate the device of Figure 1A with a lateral spacing X between the emitter and collector regions selected to be relatively large so that |Vce| is less than |Vt| and thus the device operates as a normally OFF transistor. In the present case the spacing X is such that Vce lies between Vt and Vt' allowing the device to operate with the characteristics of any of regions J,K or L depending on Vbe.

Figure 3A illustrates the normally OFF device operating in an ON majority bipolar condition (region J of Fig 2). With the emitter terminal E at a relatively positive voltage compared with the base terminal B such that Vbe is more negative that Vft, the diode junction 5B between the emitter region 3 and sub-region 4A provided by N region 101 is forward biased allowing current flow (represented by arrow 6) through the diode junction 5B between the emitter terminal E and base terminal B. Consequently, there is a corresponding but much larger current between the emitter 3 and collector 2 attributed to both unipolar flow of charge carries through the channel 4B (represented by arrow 7A), and a yet larger current attributed to bipolar conduction via the N type base region 4A (represented by arrow 7B). The occurrence of unipolar conduction through the channel 4B provides the transistor with improved gain characteristics over transistors with conventional BJT structures.

Where the collector-emitter current is large, the bipolar current 7B may be significantly larger than the unipolar current 7A (e.g. on the order of 10x larger). This compares with a JFET where all (or close to all) of its current can be attributed to unipolar conduction through the channel.

Figure 3B illustrates the device in an OFF condition represented by region K in Fig 2. $V_{CE}$ is identical to that shown in Fig 3A but the base terminal B is floating or is tied to the emitter terminal E. As a consequence there is no current through the base terminal B.

This condition gives rise to a depletion region 8 shown notionally by the dotted line about the PN junction 5 which, because the channel 4B is very shallow and weakly doped compared with the base sub-region, pinches offs the channel 4B increasing the channel's 4B resistance to an extent that there is substantially no current between the emitter 3 and collector 2.

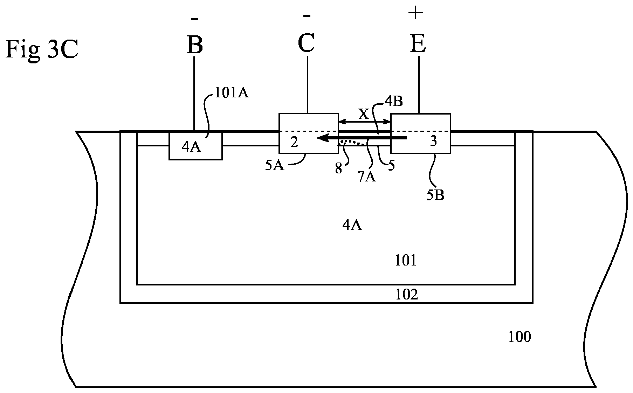

Figure 3C illustrates the device operating in an ON majority unipolar condition (region L of Fig 2) through applying a non-zero voltage Vbe across the emitter and base that is less than Vft. As Vbe is less than Vft, the diode junction 5B between the emitter 3 and N type base region 4A is not sufficiently forward bias to permit current through and so there is no current through the base terminal B or base region 4A; however, because of the channel's 4B very low net doping levels, Vbe is sufficient to reduce the depletion region 8 around diode junction 5 to an extent that allow for current through unipolar conduction between the emitter region 3 and collector region 2 via the channel 4B (represented by arrow 7A). Operating within region L, the transistor has a high gain characteristic by virtue that Ib=0A. However, because of the shallowness of the channel, the maximum current that can be obtained before the channel saturates is comparatively low compared with operation in the J region.

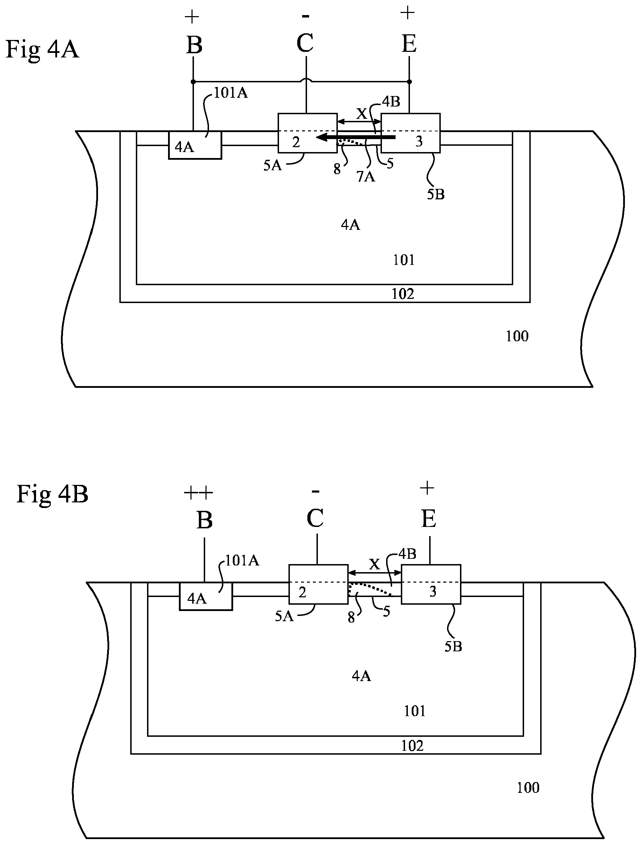

Figures 4A and 4B illustrate a variant device with an identical semiconductor structure to that of Figures 1 except with a smaller spacing X between the collector region 2 and emitter region 3 and thus a shorter channel 4B. The spacing is selected such that when operated in a circuit that provides the same Vce range to the devices of Figures 3A-3C, Vce is greater that Vt and thus the device operates as a normally ON transistor.

It should be noted that although selecting the lateral spacing between the collector and emitter regions is the most convenient method to control the channel length, it may be possible to provide a longer channel length for a given lateral emitter-collector separation distance by forming the channel having a circuitous path between the emitter and collector regions.

Figure 4A illustrates the device in an ON majority unipolar condition. $V_{CE}$ is identical to that described in relation to Figs 3A-3C but due to the closer spacing X between the collector 2 and emitter 3, and thus the shorter channel 4B, it is sufficient to overcome the intrinsic depletion region around diode junction 5 even in the condition that the base terminal B is floating or is tied to the emitter terminal E. As a consequence, although there is no current through the base terminal B, there is a current between the emitter and collector via the channel 4A.

Fig 4B illustrates the device in an OFF condition. This is achieved by making the base terminal B significantly more positive than the emitter terminal E.

Note that the surface area of the transistor, i.e. the dimension into/out of the page with respective Figs 1, 3 and 4 can be selected to increase the width of the base region including channel 4B, depending on the maximum current rating that the transistor device 1 is required to meet.

The substrate layer 100 may be connected to a low voltage to ensure that the PN junction between the substrate and the N+ layer 102 is reverse biased. This inhibits unwanted effects from parasitic lateral NPN BJT transistor between base regions of neighbouring transistors.

The N+ later 102 is required in part to prevent the P implant 103 from creating a short circuit between the emitter and substrate, and to ensure that the parasitic vertical PNP BJT formed between the emitter and the substrate has very poor current conduction characteristics, favourably reducing the parasitic current by a factor of more than 100 compared to the collector current of the device.

## Alternative Embodiment with Variant Semiconductor Structure and Method of Manufacture

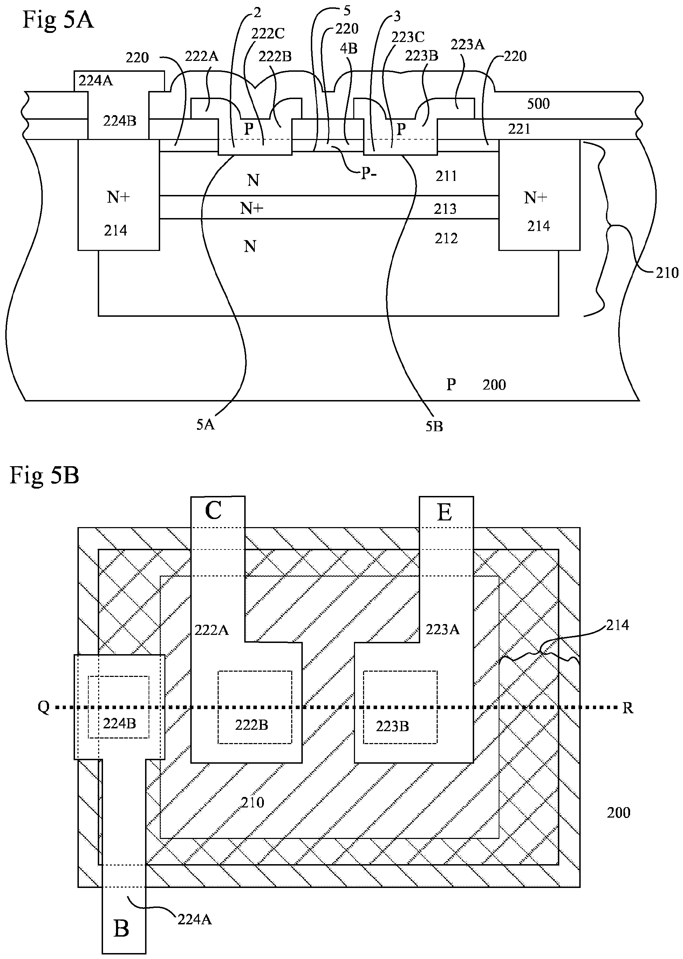

Figures 5A and 5B illustrate a variant semiconductor structure to implement the transistor device. The variant structure is advantageously easier to manufacture compared with that of Figure 1. The dotted line QR represents the axis through which the section of Figure 5A is taken.

There is provided a P type substrate 200, which may be, for example, a silicon wafer or layer deposited by epitaxy on top of the wafer. Within the substrate 200 is provided an N type well region 210 comprised from an upper N type region 211, a lower N type region 212 and an N+ type region 213 therebetween.

Surrounding the upper N type region 211 and N+ region 213 is a ring of a further N+ region 214. The N+ ring 214 overlaps with and extends outwards of the N Type well 210 to provide the N type region 4A of the transistor.

Lying above and in direct contact with the upper N type region 211 is a P- channel layer 220 that provides the channel 4B of the transistor. The P-channel layer lies in direct contact with the N type region 211 below it to provide diode junction 5.

Notably the N+ ring region 214 extends upwards, surrounding the P- channel layer 220 to isolate the channels 4B from the substrate.

The doping concentration of the N type region 211 is in the range of 1e17/cm3 to 5e17/cm3. This is in comparison to the high doping levels (>1e19/cm3) usually found in the gate of a JFET.

The P- channel layer 220 has a net doping concentration in the order of 1e16/cm3 to 1e17/cm3.

Lying over the P-channel layer 220 is an oxide layer 221 The structure also includes two separated P regions 222, 223 each extending through the oxide layer 221 and P-channel layer 220 to provide the respective collector and emitter regions 2, 3.

A first part 222A, 223A of each P region 222, 223 is provided by portions of a P doped polysilicon layer lying on the oxide layer 221 to connect the emitter and collector terminals into the circuit. A second part 222B, 223B of each P region 222, 223 is provided by portions of the polysilicon layer extending through the oxide layer 221 to contact the surface of the wafer. A third part 222C, 223C of each P region 222, 223 is formed in the silicon wafer and interfaces the N region 211 to provide respective diode junctions 5A 5B.

A patterned oxide layer 500 and a metal layer 224 lie over the oxide and polysilicon layers 221, 223. The portions 224A of the metal layer are patterned to provides conductive tracts. A second part 224B of the metal layer 224 extends through an aperture within oxide layers 500 and 221 to contact the N+ region 214 to provide the base terminal.

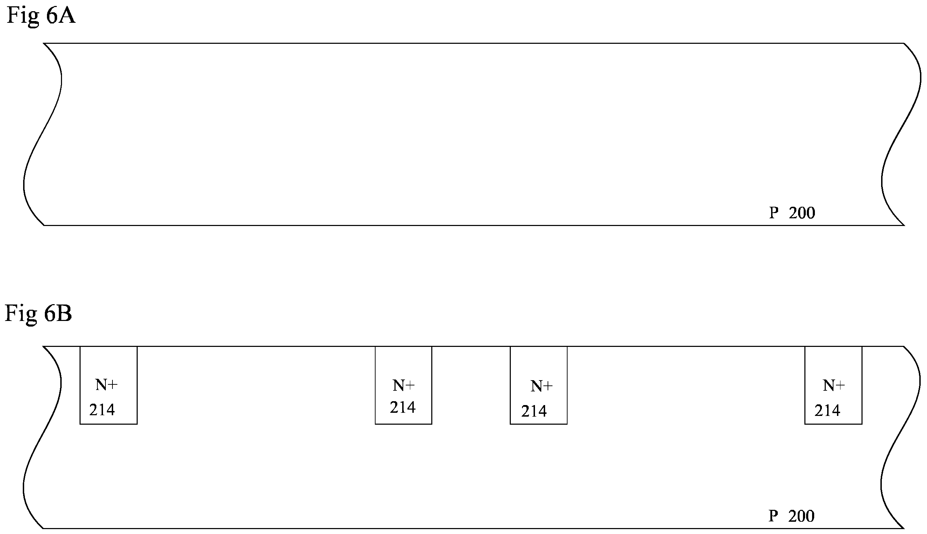

An example process for manufacturing two transistors with the structure of Figures 5A and 5B as part of an integrated circuit is illustrated with reference to Figures 6A-6I.

A first of the transistors is formed with a relatively small spacing X between the collector and emitter region and the other with a relatively large spacing, the spacing selected so that when in operation the first operates as a normally ON transistor and the other as a normally OFF transistor. The channel length of the second transistor may be selected such that it operates, when ON, with characteristics described in relation to either the L, N or J region of Fig 2.

With reference Fig 6A, a P type substrate 200 is provided. Turning to Fig 6B, a mask, implant then diffusion process is used to form separate ring shaped (circular or otherwise) N+ regions 214, one for each transistor, in a P-type wafer 200.

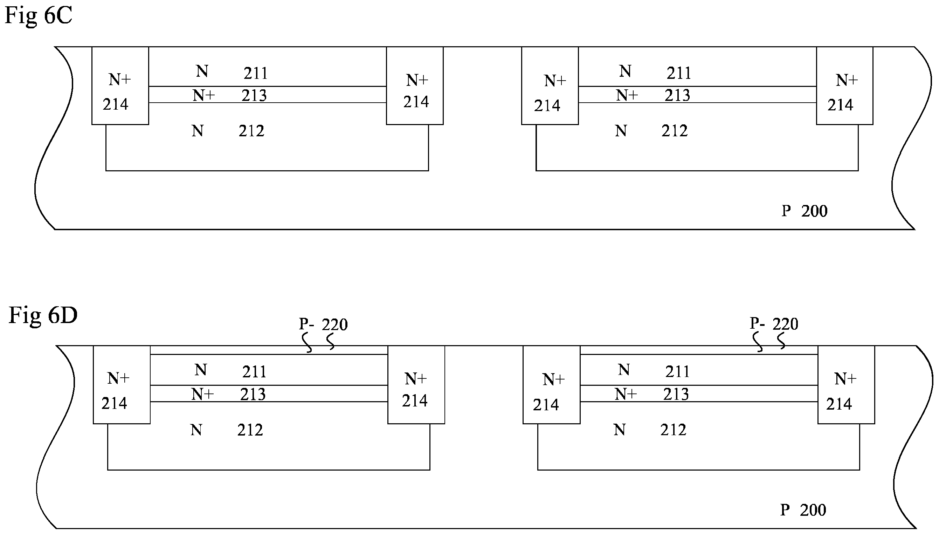

With reference Fig 6C, a mask and implant process is used to form the N type wells 210 within the respective rings 214. The diffusion process is omitted to leave the more highly doped N+ layer 213 beneath the surface, between N type layers 211, 212.

With reference Fig 6D an unmasked P type implant process is used to form the P-channel layer 220. This may be carried out without a diffusion or anneal process. Because the doping required to form the P-channel region is so weak, the implant does not determinately affect the N+ regions.

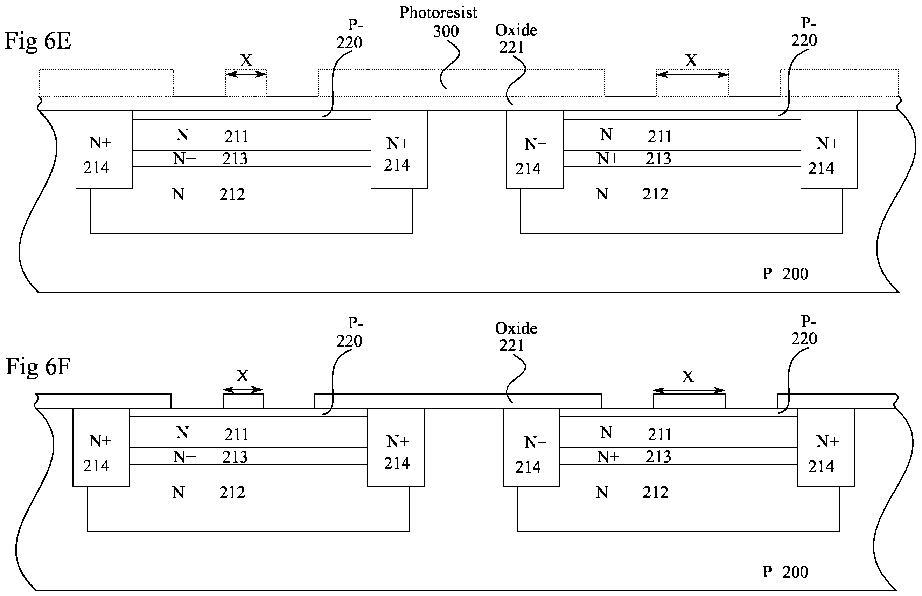

With reference Fig 6E, an oxide layer 221 is added to the wafer through a deposition process. Using a deposition process ensures the p- channel layer 220 is not harmed.

A photo resist 300 is applied over the oxide layer. The photo resist is patterned to define the spacing X between the collector and emitter regions and thus define the length of the channel 4B. The spacing X for the left hand transistor is, in this example, selected to be relatively small in order to provide a normally ON transistor, whereas the spacing X for the right hand transistor is selected to be relatively larger to provide a normally OFF transistor.

By way of example only for a 1um fabrication process size, the right hand transistor may have a channel length between 1.2microns and 1.5microns. Whereas the left hand transistor may have a channel length equal to or less than 0.8microns.

With reference Fig 6F, the oxide layer is etched and the mask removed.

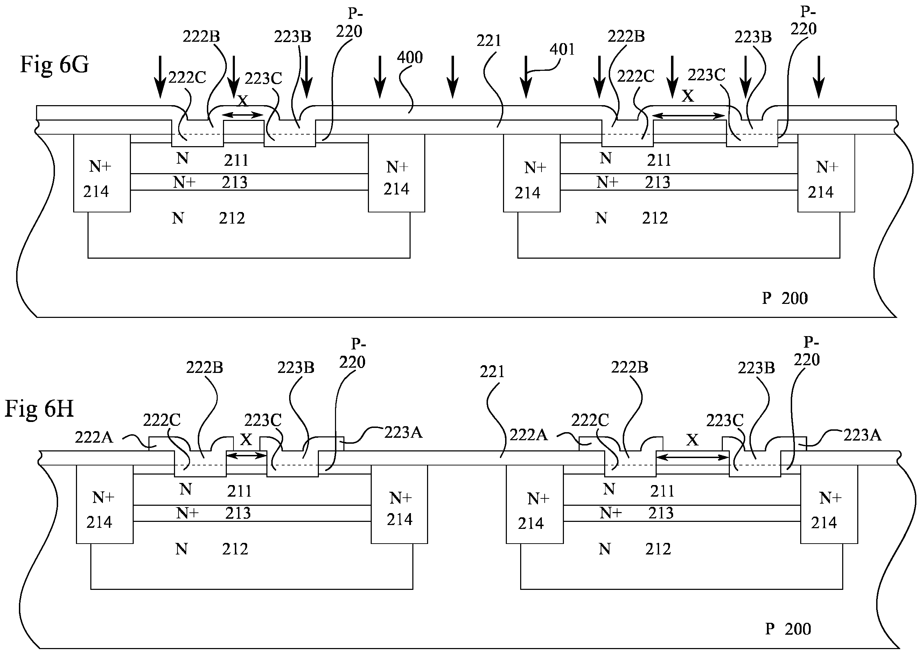

Referring to Fig 6G, a layer of polysilicon 400 is deposited over (optionally the entire) wafer. The polysilicon layer 223 directly contacts the exposed surface of the P- layer 220 where the oxide layer 221 has been removed to form the collector and emitter contacts 222B, 223B.

A P type implant process 401 (represented by arrows) is carried out to convert the polysilicon to P type, the process also increases the net doping concentration of regions of the P- layer in direct contact with the polysilicon to form regions 222C, 223C of the collector and emitter terminals 2, 3. A short anneal step activates the implant without causing diffusion of the P- channel 220. Alternatively, in order to reduce the processing time a P-type polysilicon may be deposited.

Referring to Fig 6H, the polysilicon layer 400 is masked and etched to pattern the collector and emitter terminals 2, 3 with tracks 222A 223A.

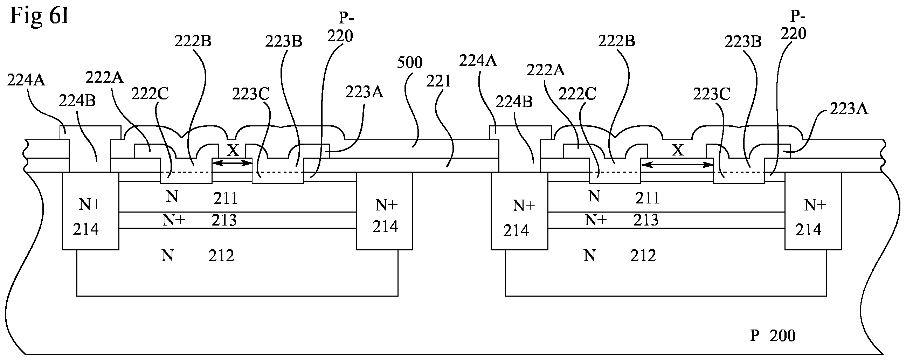

With reference to Fig 6I, a further mask and etch process is used to expose a region of the N+ ring later 214 and metal 224 deposited to provide the base contact 224B, and etched with a pattern to provide routing layer 224A.

It will be appreciated that the device as variously described above could instead by implemented as a NPN device with an N-type channel, emitter and collector regions, and a P type base sub region. Where so the device will be operated with polarities reversed to that described above.

Rather than using a polysilicon layer, the emitter region and/or the collector region may be formed wholly within the wafer.

The above described structure could be altered to incorporate a zener diode that electrically connects between the base and collector terminals through the provision of an additional P region as described in WO2019/229432.

The metal base contact could be replaced by a polysilicon doped contact. This would introduce a Zener diode into the base terminal, with the benefit of not requiring any metal layers to route close to the device.

## Claims

1. A transistor device (1) having:

   a collector region (2) provided by a first region (104) of semiconductor of a first type; a collector terminal associated with the collector region (2); an emitter region (3) provided by a second region of semiconductor (105) of the first type; an emitter terminal associated with the emitter region (3);
   a base region (4A, 4B) provided by a third region (101,103) of semiconductor lying between and interfacing with both the collector region (2) and emitter region (3); a base terminal associated with the base region;
   wherein the base region (4A, 4B) includes:

      a sub-region (4A) of semiconductor of a second type; and
      a channel (4B) of semiconductor of the first type;

   wherein the base terminal contacts the sub-region (4A);
   the sub-region(4A) interfaces with the channel (4B) to provide a first diode junction (5), and interfaces with both the emitter region (3) and the collector region (2) to form further diode junctions;
   the channel (4B) interfaces with and interconnects the collector region (2) and the emitter region (3);
   the net doping concentration of the channel (4B) is less than the net doping concentration of the emitter and collector regions (2, 3); the channel (4B) has a depth extending away from the first diode junction (5); and
   **characterised in that** there is a separation between the collector and the emitter regions (2, 3) which is sufficiently small such that when implemented in a circuit where there is a voltage across the emitter and base terminals such as to cause a current through the base terminal, a current between the collector and emitter terminals is at least predominantly attributable to bipolar conduction, said separation being less than or equal to 1.5 microns; and
   that the sub region (4A) lies in a semiconductor substrate layer (100) of the first type.

2. A transistor device of claim 1 wherein the channel has a depth extending from the first diode junction of less than or equal to 0.25 micron.

3. A transistor device according to claim 1 or 2 wherein the sub-region of the base region comprises a first portion and a second portion, and wherein:

the first portion has a higher net doping concentration than the second portion;
the base terminal electrically connects to the second portion through the first portion; and
in which the second portion interfaces with the channel to provide the first diode junction, and interfaces with both the emitter region and the collector region to form the further diode junctions.

4. A transistor device according to claim 3 wherein the net doping concentration of the channel is less than or equal to one times the net doping concentration of second portion of the sub-region.

5. A transistor device according to claim 4 wherein the net doping concentration of the channel is less than or equal 0.1 times the net doping concentration of the second portion of the sub-region.

6. A transistor device according to claim 5 wherein the second portion of the sub-region of the base has a net doping concentration of between 5e16/cm3 to 5e17/cm3.

7. A transistor device according to claim 6 wherein the first portion of the sub-region of the base has a net doping concentration greater or equal to 1e18/cm3.

8. A transistor device according to any previous claim wherein the emitter region and/or collector region are provided by a doped polysilicon layer provided on a silicon die that defines the base region.

9. An integrated circuit comprising two transistors of any previous claim wherein

the channel of a first of the transistor devices is relatively long and there is a relatively large lateral spacing between the collector region and emitter region of the first transistor device and the channel of the second of the transistor devices is relatively short and
the second transistor device has a relatively small lateral spacing between its collector and emitter regions.

10. A method of operating the integrated circuit of claim 9 in which both the first and second transistor devices are operated within the same collector-emitter voltage range which is selected such that the first transistor device operates as a normally off transistor and second transistor device operate as normally on transistor

11. A method of manufacturing an integrated circuit comprising two transistor devices of claim 1, the method comprising fabricating a first of the transistor devices to have a first lateral spacing between the emitter and collector regions, and fabricating a second of the transistor devices with a second lateral spacing between the emitter and collector regions, the first and second lateral spacing being different.

12. A method according to claim 11 comprising: using the same mask to define the transistor devices. spacing between the emitter and collector regions of both first and second

13. A method of operating the transistor device of any claim 1 to 8

wherein when the device is ON $|Vce| < |Vft|$, and $|Vbe| <= |Vce|$
where Vce is the voltage across the collector and emitter terminals,
Vft is the forward bias voltage of the base emitter diode junction; and
Vbe is the voltage across the collector and emitter terminals

14. A method according to claim 13 wherein $|Vce| \leq \frac{1}{2} |Vft|$.

15. A method according to claim 13 or 14 wherein when the OFF state:

$$|Vbe| < |Vft|.$$

**Patentansprüche**

1. Ein Transistor (1) mit:

einem Kollektorbereich (2), der von einem ersten Halbleiterbereich (104) von einem ersten Typ bereit gestellt wird; einem Kollektor-Terminal, der mit dem Kollektorbereich (2) verknüpft ist;
einem Senderbereich (3), der von einem zweiten Halbleiterbereich (104) von einem zweiten Typ bereit gestellt wird; einem Senderterminal, der mit dem Senderbereich (3) verknüpft ist:

einem Basisbereich (4A, 4B), der von einem dritten Halbleiterbereich (101,103) bereit gestellt wird, der zwischen dem Kollektorbereich (2) und dem Senderbereich (3) liegt und beide verbindet; einem Basisterminal, der mit dem Basisbereich verknüpft ist; wobei der Basisbereich (4A, 4B) Folgendes umfasst:

    einen Halbleiter-Unterbereich (4A) von einem zweiten Typ; und
    einen Halbleiter-Kanal (4B) vom ersten Typ;

wobei der Basis-Terminal den Unterbereich (4A) kontaktiert.

Der Unterbereich (4A) bildet eine Schnittstelle mit dem Kanal (4B), um den ersten Diodenanschluss (5) bereitzustellen und verbindet den Senderbereich (3) mit dem Kollektorbereich (2), um weitere Diodenanschlüsse zu bilden;

der Kanal (4B) bildet eine Schnittstelle zum Kollektorbereich (2) und dem Senderbereich (3) und stellt wechselseitige Verbindungen her;

die Netto-Dotierungskonzentration des Kanals (4B) ist weniger als die Netto-Dotierungskonzentration der Sender- und Kollektorbereiche (2, 3); der Kanal (4B) hat eine Vertiefung, die vom ersten Diodenanschluss (5) wegführt; und

ist dahingehend charakterisiert, dass eine Trennung zwischen den Kollektor- und Senderbereichen (2, 3) besteht, die ausreichend klein ist, dass beim Einbau in einen Stromkreis eine Spannung auf den Sender- und Basisterminals liegt, sodass Strom durch den Basis-Terminal, und Strom zwischen den Kollektor- und Senderterminalen fließt, der zumindest vorrangig auf bipolare Konduktion zurückzuführen ist, wobei die besagte Trennung kleiner oder gleich 1,5 Mikrometer ist; und

dass der Unterbereich (4A) in einer Halbleiter-Substratschicht (100) des ersten Typs liegt.

**2.** Ein Transistor aus Anspruch 1, wobei der Kanal eine Vertiefung aufweist, die vom ersten Diodenanschluss weniger oder gleich 0,25 Mikrometer wegragt.

**3.** Ein Transistor aus Anspruch 1 oder 2, wobei der Unterbereich des Basisbereichs aus einen ersten und einem zweiten Teil besteht, und wobei:

    der erste Teil eine höhere Netto-Dotierungskonzentration aufweist als der zweite Teil;
    der Basis-Terminal durch die erste Portion elektrisch an die zweite Portion angeschlossen ist; und
    wobei der zweite Teil eine Schnittstelle mit dem Kanal bildet, um den ersten Diodenanschluss bereitzustellen, und Schnittstellen mit dem Senderbereich und dem Kollektorbereich bildet, um die weiteren Diodenanschlüsse zu bilden.

**4.** Ein Transistor gemäß Anspruch 3, wobei die Netto-Dotierungskonzentration des Kanals weniger oder gleich dem Einfachen der Netto-Dotierungskonzentration des zweiten Teils des Unterbereichs ist.

**5.** Ein Transistor gemäß Anspruch 4, wobei die Netto-Dotierungskonzentration des Kanals weniger oder gleich dem 0,1-Fachen der Netto-Dotierungskonzentration des zweiten Teils des Unterbereichs ist.

**6.** Ein Transistor gemäß Anspruch 5, wobei der zweite Teil des Unterbereichs der Basis eine Netto-Dotierungskonzentration von $5e16/cm^3$ bis $5e17/cm^3$ aufweist.

**7.** Ein Transistor gemäß Anspruch 6, wobei der erster Teil des Unterbereichs der Basis eine Netto-Dotierungskonzentration von größer oder gleich $1e18/cm^3$ aufweist.

**8.** Ein Transistor gemäß einem der vorherigen Ansprüche, wobei der Senderbereich und/oder Kollektorbereich von einer dotierten Polysiliziumschicht auf einer Siliziumscheibe bereitgestellt wird, die den Basisbereich definiert.

**9.** Ein integrierter Schaltkreis, der aus zwei Transistoren aus den vorherigen Ansprüchen besteht, wobei der Kanal von einem ersten der Transistoren relativ lang ist und ein relativ großer lateraler Abstand zwischen dem Kollektorbereich und dem Senderbereich des ersten Transistors besteht und der Kanal des zweiten Transistors relativ kurz ist und der zweite Transistor einen relativ kleinen lateralen Abstand zwischen seinen Kollektoren- und Senderbereichen aufweist.

**10.** Eine Methode, um den integrierten Schaltkreis von Anspruch 9 zu betreiben, wobei der erste und zweite Transistor innerhalb des gleichen Kollektor-Sender-Spannungsbereichs betrieben werden, der so ausgewählt wurde, dass der erste Transistor normalerweise als der abgeschaltete Transistor und der zweite Transistor normalerweise als der eingeschaltete Transistor betrieben wird.

**11.** Eine Methode zur Herstellung eines integrierten Schaltkreises, der aus zwei Transistoren aus Anspruch 1 besteht, wobei bei der Herstellung des ersten Transistoren ein erster lateraler Abstand zwischen den Sender- und Kollektorbereichen integriert werden soll, und bei der Herstellung eines zweiten Transistors mit ein zweiter lateraler Abstand zwischen den Sender- und Kollektorbereichen integriert werden soll, wobei der erste und zweite laterale Abstand unterschiedlich sind.

12. Eine Methode nach Anspruch 11, die Folgendes umfasst: Verwendung der gleichen Maske, um die Transistoren zu definieren.
Abstand zwischen den Sender- und Kollektor-Bereichen für den ersten und zweiten Transistor

13. Eine Methode zum Betreiben des Transistors aus einem der Ansprüche 1 bis 8, wobei das Gerät EIN |Vce| < |Vft |ist, und |Vbe| <= |Vce|, wobei Vce die Spannung an Kollektor- und Senderterminals ist, Vft bezeichnet die Durchlassspannung des Diodenanschlusses des Basissenders; und Vbe bezeichnet die Spannung an den Kollektor- und Sender-Terminals.

14. Eine Methode gemäß Anspruch 13, wobei |Vce| ≤ ½ |Vft| ist.

15. Eine Methode gemäß Anspruch 13 oder 14, wobe im AUS-Zustand gilt: |Vbe| <|Vft|.

**Revendications**

1. La présente invention concerne un transistor (1) comportant :

une région collectrice (2) constituée d'une première région (104) de semi-conducteur d'un premier type ; une borne collectrice associée à la région collectrice (2) ;
une région émettrice (3) constituée d'une deuxième région de semi-conducteur (105) du premier type ; une borne émettrice associée à la région émettrice (3) ;
une région de base (4A, 4B) constituée d'une troisième région (101, 103) de semi-conducteur située entre et en interface avec la région collectrice (2) et la région émettrice (3) ; une borne de base associée à la région de base ;
dans laquelle la région de base (4A, 4B) comprend :

une sous-région (4A) de semi-conducteur d'un second type ; et
un canal (4B) de semi-conducteur du premier type ;

dans lequel la borne de base est en contact avec la sous-région (4A) ;
la sous-région (4A) est en interface avec le canal (4B) pour former une première jonction de diode (5), et est en interface à la fois avec la région émettrice (3) et la région collectrice (2) pour former d'autres jonctions de diode ;
le canal (4B) est en interface avec la région collectrice (2) et la région émettrice (3) et les relie entre elles ;
la concentration nette de dopage du canal (4B) est inférieure à la concentration nette de dopage des régions émettrice et collectrice (2, 3) ; le canal (4B) a une profondeur qui s'étend à l'écart de la première jonction de diode (5) ; et
**caractérisé en ce qu'**il existe une séparation entre les régions collectrice et émettrice (2, 3) qui est suffisamment petite pour que, lorsqu'elle est mise en oeuvre dans un circuit où il existe une tension entre les bornes émettrice et de base telle qu'elle provoque un courant à travers la borne de base, un courant entre les bornes collectrice et émettrice soit au moins principalement attribuable à la conduction bipolaire, ladite séparation étant inférieure ou égale à 1,5 micron ; et
la sous-région (4A) se trouve dans une couche de substrat semi-conducteur (100) du premier type.

2. Transistor selon la revendication 1 dans lequel le canal a une profondeur s'étendant à partir de la première jonction de diode inférieure ou égale à 0,25 micron.

3. Transistor selon la revendication 1 ou 2, dans lequel la sous-région de la région de base comprend une première partie et une deuxième partie, et dans lequel :

la première partie présente une concentration nette de dopage plus élevée que la deuxième partie ;
la borne de base se connecte électriquement à la deuxième partie à travers la première partie ; et
dans lequel la deuxième partie fait interface avec le canal pour former la première jonction de diode, et fait interface à la fois avec la région émettrice et la région collectrice pour former les autres jonctions de diode.

4. Transistor selon la revendication 3, dans lequel la concentration nette de dopage du canal est inférieure ou égale à une fois la concentration nette de dopage de la deuxième partie de la sous-région.

5. Transistor selon la revendication 4, dans lequel la concentration nette de dopage du canal est inférieure ou égale à 0,1 fois la concentration nette de dopage de la deuxième partie de la sous-région.

6. Transistor selon la revendication 5 dans lequel la deuxième partie de la sous-région de la base présente une concentration nette de dopage comprise entre 5e16/cm3 et 5e17/cm3.

**7.** Transistor selon la revendication 6 dans lequel la première partie de la sous-région de la base présente une concentration nette de dopage supérieure ou égale à 1e18/cm3.

**8.** Transistor selon l'une quelconque des revendications précédentes, dans lequel la région émettrice et/ou la région collectrice sont assurées par une couche de polysilicium dopé disposée sur un dé de silicium qui définit la région de base.

**9.** Circuit intégré comprenant deux transistors selon l'une des revendications précédentes, dans lequel le canal du premier transistor est relativement long et l'espacement latéral entre la région collectrice et la région émettrice du premier transistor est relativement grand, et le canal du deuxième transistor est relativement court et le deuxième transistor présente un espacement latéral relativement petit entre ses régions collectrice et émettrice.

**10.** Procédé de fonctionnement du circuit intégré de la revendication 9, dans laquelle le premier et le deuxième transistor fonctionnent dans la même plage de tension collecteur-émetteur qui est sélectionnée de telle sorte que le premier transistor fonctionne comme un transistor normalement fermé et que le deuxième transistor fonctionne comme un transistor normalement ouvert.

**11.** Procédé de fabrication d'un circuit intégré comprenant deux transistors de la revendication 1, le procédé comprenant la fabrication d'un premier transistor ayant un premier espacement latéral entre les régions émetteur et collecteur, et la fabrication d'un deuxième transistor ayant un second espacement latéral entre les régions émettrice et collectrice, le premier et le second espacement latéral étant différents.

**12.** Procédé selon la revendication 11, comprenant : l'utilisation du même masque pour définir l'espacement des transistors entre les régions émettrice et collectrice du premier et du deuxième transistor

**13.** Procédé de fonctionnement du transistor de l'une quelconque des revendications 1 à 8, dans lequel, lorsque le dispositif est à l'état ON |Vce| < | Vft |, et | Vbe| <= |Vce| où Vce est la tension aux bornes collectrice et émettrice, Vft est la tension de polarisation directe de la jonction diode base-émetteur ; et Vbe est la tension aux bornes collectrice émettrice.

**14.** Procédé selon la revendication 13 dans lequel |Vce| ≤ ½ |Vft|.

**15.** Procédé selon la revendication 13 ou 14 dans lequel, à l'état OFF |Vbe| <|Vft|.

Fig 1

# Fig 2

Fig 3A

B C E
− − +

Fig 3B

B C E
+ − +

Fig 3C

B
−

C
−

E
+

101A

4B
X

4A

2

3

5A
8
7A
5

5B

4A

101

102

100

Fig 4A

Fig 4B

Fig 5A

Fig 5B

Fig 6A

P 200

Fig 6B

| N+ 214 | | N+ 214 | N+ 214 | | N+ 214 |

P 200

## Fig 6C

| N+ 214 | N    211 |  |
|        | N+   213 | N+ 214 |
|        | N    212 |  |

| N+ 214 | N    211 |  |
|        | N+   213 | N+ 214 |
|        | N    212 |  |

P  200

## Fig 6D

P- 220

| N+ 214 | N    211 |  |
|        | N+   213 | N+ 214 |
|        | N    212 |  |

P- 220

| N+ 214 | N    211 |  |
|        | N+   213 | N+ 214 |
|        | N    212 |  |

P  200

EP 4 070 384 B1

Fig 6E

Photoresist 300

P- 220    Oxide 221    P- 220

X    X

| N+ 214 | N    211 | | N+ 214 | | N+ 214 | N    211 | N+ 214 |
| | N+   213 | | | | N+   213 | |
| | N    212 | | | | N    212 | |

P  200

Fig 6F

P- 220    Oxide 221    P- 220

X    X

| N+ 214 | N    211 | | N+ 214 | | N+ 214 | N    211 | N+ 214 |
| | N+   213 | | | | N+   213 | |
| | N    212 | | | | N    212 | |

P  200

EP 4 070 384 B1

Fig 6G

Fig 6H

Fig 6I

EP 4 070 384 B1

**EP 4 070 384 B1**

**REFERENCES CITED IN THE DESCRIPTION**

**Patent documents cited in the description**

- US 6251716 B1
- US 200316704 A1
- US 2009206375 A
- US 4496963 A
- EP 0268426 A
- WO 2011053932 A
- US 6251716 B
- WO 2019229432 A